# EUROPEAN PATENT SPECIFICATION

(11) **EP 3 023 603 B1**
(45) Date of publication and mention of the grant of the patent: **13.03.2019**
(21) Application number: 15194348.7
(22) Date of filing: 12.11.2015
(51) Int. Cl.: G01M 15/14, H05K 1/02, H05K 1/03, F01D 17/02, F01D 25/00, F01D 5/28, H05K 1/18

(54) **INSTRUMENTED ARTICLE HAVING COMPLIANT LAYER BETWEEN CONFORMAL ELECTRONIC DEVICE AND SUBSTRATE**
INSTRUMENTIERTER ARTIKEL MIT NACHGIEBIGER SCHICHT ZWISCHEN KONFORMER ELEKTRONISCHER VORRICHTUNG UND SUBSTRAT
ARTICLE INSTRUMENTÉ DOTÉ D'UNE COUCHE CONFORME ENTRE UN DISPOSITIF ÉLECTRONIQUE ET UN SUBSTRAT

(30) Priority: 12.11.2014 US 201462078446 P
(43) Date of publication of application: 25.05.2016
(73) Proprietor: United Technologies Corporation, Farmington, CT 06032 (US)
(72) Inventor: SHEEDY, Paul, Bolton, CT 06043 (US); DARDONA, Sameh, South Windsor, CT 06074 (US); McCAFFREY, Michael G., Windsor, CT 06095 (US); SCHMIDT, Wayde R., Pomfret Center, CT 06259 (US); CULP, Slade R., Coventry, CT 06238 (US)
(74) Representative: Dehns

(56) References cited:
- EP-A2- 1 734 025
- WO-A2-2008/091289
- FR-A1- 2 899 226
- US-A1- 2004 202 886
- US-A1- 2012 197 597

## Description

### BACKGROUND

A gas turbine engine typically includes a fan section, a compressor section, a combustor section and a turbine section. The design of articles in these sections often relies on measurements of the operating conditions, such as temperature, pressure, strain, etc. To obtain such measurements, an external sensor or instrument can be attached to the article at the location of interest. However, such external sensors may be difficult to affix at the desired location and are obtrusive in that the external sensors can influence the performance of the article and thus taint the data collected from the measurements.

US 2004/0202886 discloses a prior art instrumented article according to the preamble of claim 1.

### SUMMARY

According to the present invention, there is provided an instrumented article as set forth in claim 1.

In a further embodiment of the foregoing embodiment, the ceramic-based substrate includes a silicon-based ceramic material.

In a further embodiment of any of the foregoing embodiments, the ceramic-based substrate is a monolithic ceramic material.

In a further embodiment of any of the foregoing embodiments, the conformal electronic device includes conformal conductive lead wires.

In a further embodiment of any of the foregoing embodiments, the compliant layer is a silicate.

In a further embodiment of any of the foregoing embodiments, the compliant layer is a rare-earth silicate.

In a further embodiment of any of the foregoing embodiments, the compliant layer is yttrium silicate.

In a further embodiment of any of the foregoing embodiments, the compliant layer is compositionally graded.

In a further embodiment of any of the foregoing embodiments, the compliant layer is compositionally graded with respect to concentration of yttrium disilicate, yttrium monosilicate, and silica.

In a further embodiment of any of the foregoing embodiments, the at least one conformal electronic device includes a plurality of different kinds of conformal electronic devices.

In a further embodiment of any of the foregoing embodiments, the at least one conformal electronic device includes a plurality of conformal electronic devices, and the conformal electronic devices are stacked at different vertical distances from the surface of the ceramic-based substrate.

A further embodiment of any of the foregoing embodiments includes respective interleave layers between, and separating, the conformal electronic devices.

A further embodiment of any of the foregoing embodiments a protective layer over the at least one conformal electronic device.

A further embodiment of any of the foregoing embodiments a bond layer located between the protective layer and the at least one conformal electronic device.

In a further embodiment of any of the foregoing embodiments, the ceramic-based substrate is a gas turbine engine article defining, relative to one another, a hot surface zone and a cold surface zone, and the at least one conformal electronic device is located in the hot surface zone, with conformal lead wires that are connected to the at least one conformal electronic device, and the conformal lead wires extend from the at least one conformal electronic device and terminate in the cold surface zone.

### BRIEF DESCRIPTION OF THE DRAWINGS

The various features and advantages of the present disclosure will become apparent to those skilled in the art from the following detailed description. The drawings that accompany the detailed description can be briefly described as follows.
Figure 1 illustrates a representative portion of an instrumented article that has a substrate, a conformal electronic device, and a compliant layer there between.
Figure 2 illustrates a representative portion of another example instrumented article that has a bond layer between the compliant layer and the substrate.
Figure 3 illustrates a representative portion of another example instrumented article that has a protective layer over the conformal electronic device.
Figure 4 illustrates a representative portion of another example instrumented article that has a bond coat underneath the overlying protective layer.
Figure 5 illustrates a representative portion of another example instrumented article having a plurality of conformal electronic devices in a stacked arrangement.
Figure 6A illustrates an instrumented article that is a blade outer air seal with several conformal electronic devices that have conformal lead wires that extend to a cold surface zone.
Figure 6B illustrates the cold surface zone side of the instrumented article of Figure 6A.

### DETAILED DESCRIPTION

Gas turbine engines and other machines can utilize ceramic-based or other high-temperature materials to permit use of higher operating temperatures. A drawback, however, is that instruments that have been used in lower temperature conditions on metallic alloys for obtaining measurements of operating conditions, such as temperature, pressure, strain, etc., do not perform as needed with ceramic-based or other high-temperature materials under the more severe temperature conditions. For example, proper operation of an instrument relies on adherence to the surface of the article in the location of interest. The surface of a metallic alloy can be roughened to facilitate adhesion, with insignificant influence on the properties of the metallic alloy from the roughening. However, ceramic-based or other high-temperature materials can be notch-sensitive and roughening thus reduces toughness, which in turn can lead to premature cracking and skewed measurements. If the ceramic-based or other high-temperature material is not roughened, the instrument can prematurely detach, either ruining or skewing the measurements.

Rather than attaching a pre-existing external instrument, conformal electronic devices can be used for obtaining measurements of operating conditions. A conformal electronic device is a device that has one or more functional conductive elements in mechanical conformity with the underlying substrate/article. Such elements can be deposited on a substrate by any of various techniques, including but not limited to, printing (e.g., screen, inkjet, aerosol jet), vapor deposition, chemical deposition, thermal spraying, extrusion, kinetic (cold) spraying and wire arc methods. Conformal electronic devices, however, suffer from the same problem as external instruments in that conformal devices are difficult to directly adhere to ceramic-based or other high-temperature materials without either premature detachment or debit to the properties of the ceramic-based or other high-temperature material from roughening.

In the above regards, and as will be described in further detail, disclosed herein is an instrumented article that has at least one conformal electronic device deposited on a surface of a substrate, and a compliant layer located between the substrate and the conformal electronic device. The compliant layer can serve to mitigate thermo-mechanical forces that can otherwise cause detachment. The compliant layer can thus enhance adherence.

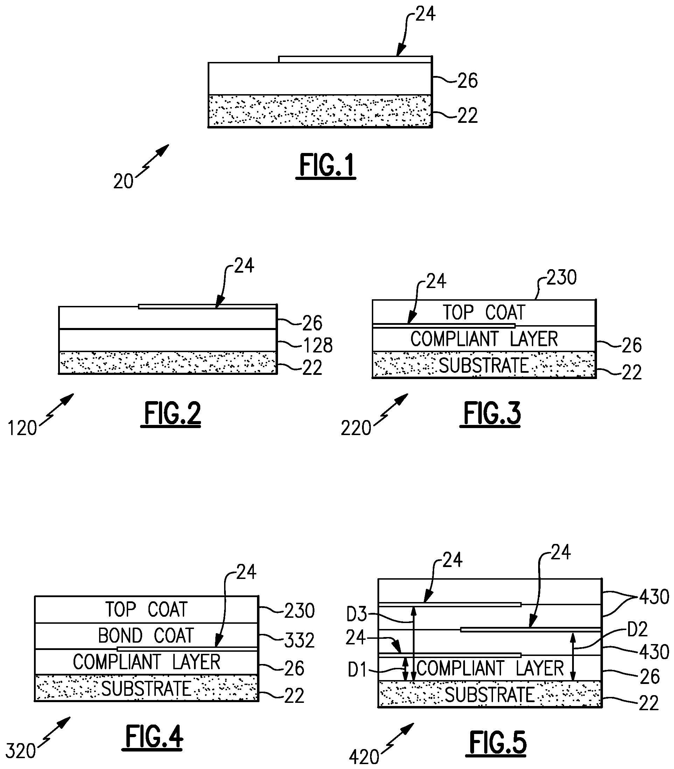

Figure 1 schematically illustrates a representative portion of an instrumented article 20. As will be appreciated, the article 20 can be a gas turbine engine article, such as but not limited to, a blade outer air seal, airfoils such as blades and vanes, a combustor, or the like. The examples herein will also be applicable to other types of articles that operate in severe environments.

In this example, the article 20 includes a substrate 22 and at least one conformal electronic device 24 deposited on a surface of the substrate 22. For example, the substrate 22 substantially has the geometry of a functional gas turbine engine article and could thus operate as intended in the end-use without further processing or modification. A compliant layer 26 is located between the substrate 22 and the conformal electronic device 24. The compliant layer 26 bonds the at least one conformal electronic device 24 and the substrate 22 together. The conformal electronic device 24 is independent of the compliant layer 26 and the substrate 22. That is, the conformal electronic device 24 would otherwise be functional without the compliant layer 26 and substrate 22.

There can be a difference in thermal expansion (e.g., coefficient of thermal expansion) between the conformal electronic device 24 and the underlying substrate 22. The difference can be especially pronounced for ceramic-based or other high-temperature substrates. Differences in thermal expansion can cause detachment of such conformal electronic devices when subjected to thermo-mechanical forces. In this regard, the compliant layer 26 has a thermal expansion that is intermediate of the thermal expansions of, respectively, the substrate 22 and the conformal electronic device 24. The compliant layer 26 thus mitigates the difference in thermal expansion between the conformal electronic device 24 and the underlying substrate 22 such that conformal electronic device 24 better adheres under relatively high temperature conditions.

The compliant layer 26 can also enhance mechanical adherence of the conformal electronic device 24 to the substrate 22. For example, the compliant layer 26 can have a controlled surface roughness or other physical characteristics to promote bonding in addition to or in place of thermal expansion matching. The compliant layer 26 can further facilitate bonding over longer periods by also serving as a chemical/reactivity barrier between the substrate 22 and the conformal electronic device 24.

The conformal electronic device or devices 24 serves as a functional sensor/instrument for the collection of data signals during operation of the article 20. The type of conformal electronic device or devices 24 selected depends on what information is desired about the operating conditions. In this regard, the conformal electronic device or devices 24 can include, but are not limited to, thermocouples, strain gauges, antennas, accelerometers, communication components, heaters, or other functional devices or devices that rely on electrical conductivity for function.

In one example, the substrate 22 can be a monolithic ceramic material or a ceramic matrix composite. A ceramic matrix composite includes a continuous or discontinuous matrix phase through which at least one reinforcement phase is dispersed. For example, the matrix phase can be a ceramic-based material and the reinforcement phase can be the same or different ceramic-based material, carbon, glass, metal, intermetallic, or other such reinforcement. A monolithic ceramic material can include one or more phases, nominally distributed in a homogeneous arrangement throughout the substrate 22.

In further examples, the substrate 22 includes one or more phases selected from oxides, borides, carbides, nitrides, silicates, glasses, glass ceramics, silicides, or combinations thereof. In one further example, the substrate 22 includes a silicon-containing ceramic material. Example silicon-containing ceramic materials can include, but are not limited to, silicon carbide, silicon nitride, silicon oxycarbide, silicon oxynitride, silicon oxycarbonitride, or combinations thereof.

In further examples, the compliant layer 26 includes one or more phases selected from oxides, carbides, borides, nitrides, oxynitrides, glasses, glass ceramics, or combinations thereof. In one example for a silicon-containing ceramic substrate 22, the compliant layer 26 is, or includes or primarily includes, a silicate material. For example, the silicate material is a rare-earth silicate, such as but not limited to, yttrium silicate. Yttrium silicate can include yttrium mono-silicate, yttrium di-silicate, or mixtures thereof. In one further example, the compliant layer 26 is compositionally graded. For example, the compliant layer 26 is compositionally graded with respect to concentration of yttrium di-silicate and yttrium mono-silicate, or alternatively silica. Yttrium di-silicate has relatively low thermal expansion in comparison to yttrium mono-silicate. In this regard, a higher concentration of yttrium di-silicate can be used at or near a ceramic-based substrate 22, which also has a relatively low thermal expansion. With increasing distance from the surface of the substrate 22, the concentration of yttrium mono-silicate, which has a relatively higher thermal expansion, increases and the concentration of yttrium di-silicate decreases. In some instances, it may be desirable to further reduce the silica concentration of the yttrium silicate such that in some locations, the compliant layer fully or substantially includes yttrium oxide.

Figure 2 schematically illustrates a representative portion of another example instrumented article 120. In this example, the article 120 is similar to the article 20 with the exception that there is a bond layer 128 located between the compliant layer 26 and the substrate 22. The composition of the bond layer 128 can be selected based upon compatibility with the composition of a ceramic-based material of the substrate 22 and the composition of the compliant layer 26. In some examples based on use of a silicon-containing ceramic material for the compliant layer 26 and a silicon-containing ceramic material in the substrate 22, the bond layer 128 is also a silicon-containing ceramic material of a different composition. For example, the bond layer 128 can include silicon metal, silicon-based intermetallics, silicon-based MAX phases, silicon carbide, silicon oxycarbide, silicon oxycarbonitride, silicon-based glasses and glass ceramics, or mixtures thereof.

Figure 3 schematically illustrates a representative portion of another example instrumented article 220. In this example, the article 220 is somewhat similar to the article 20 but with a protective layer 230 over the conformal electronic device 24, with respect to the underlying substrate 22. The protective layer 230 facilitates the protection of the conformal electronic device 24 from thermal, mechanical, and/or environmental effects. In a further example, the protective layer 230 is a ceramic-based material, such as but not limited to, a zirconia-, hafnia-, silica-, boron, aluminum, magnesium, calcium, strontium, barium, titanium, yttrium, gadolinium, lutetium, lanthanum, cerium, neodymium, dysprosium, containing ceramic material. In further examples, the protective layer 230 is or includes metal alloys, intermetallics, oxides, borides, nitrides, carbides, silicates, phosphates, or combinations thereof, selected from zirconium, hafnium, silicon, boron, aluminum, magnesium, calcium, strontium, barium, titanium, cobalt, iron, chromium, nickel, copper, yttrium, scandium, gadolinium, lutetium, lanthanum, cerium, neodymium, dysprosium, and combinations thereof.

Figure 4 schematically illustrates a representative portion of another example instrumented article 320. In this example, the article 320 is somewhat similar to the article 220 but with a bond coat 332 located between the protective layer 230 and the underlying conformal electronic device 24 and compliant layer 26. The bond coat 332 facilitates the adherence of the protective layer 230. For example, the composition of the bond coat 332 can be selected in accordance with the composition of the protective layer 230 and the underlying compliant layer 26. In one example, the bond coat 332 is MCrAlY, where M includes at least one of iron, nickel and cobalt, Cr is chromium, A1 is aluminum, and Y is yttrium. In another example, the bond coat 332 can include silicon metal, silicon-based intermetallics, silicon-based MAX phases, silicon carbide, silicon oxycarbide, silicon oxycarbonitride, silicon-based glasses and glass ceramics, or mixtures thereof.

Figure 5 schematically illustrates a representative portion of another example instrumented article 420. In this example, the article 420 includes a plurality of the conformal electronic devices 24 that are stacked at different vertical distances, represented at D1, D2, and D3, from the surface of the substrate 22. Interleave layers 430 are located between the conformal electronic devices 24 to separate the device 24 from one another. For example, the interleave layers 430 can have a composition that is the same as the composition of the protective layer 230 described above.

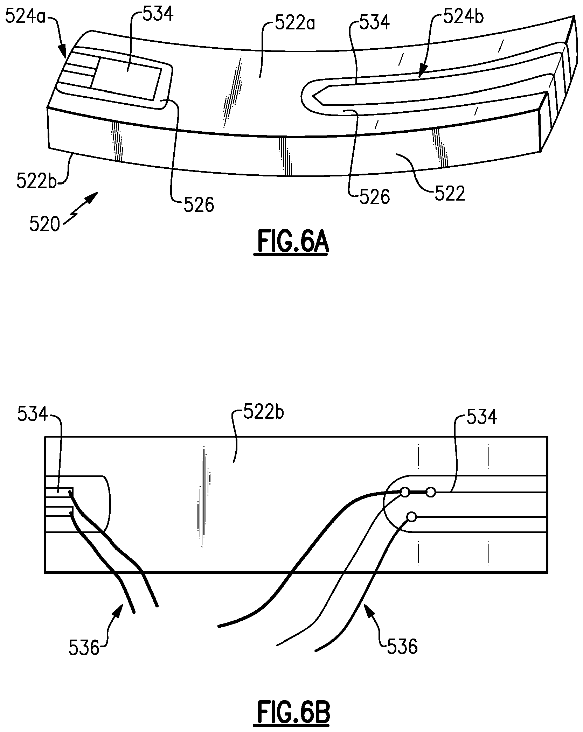

Figures 6A and 6B show different views of another example instrumented article 520. In this example, the instrumented article 520 is a portion of a blade outer air seal of a gas turbine engine. Blade outer air seals are used radially outboard of rotors to limit escape of working gases around the tips of the rotors during operation. In this example, the article 520 includes the ceramic-based substrate 522, conformal electronic devices 524a/524b, and the compliant layer 526 located between each of the conformal electronic devices 524a/524b and the underlying substrate 522. For example, the conformal electronic device 524a is a strain gauge and the conformal electronic device 524b is a thermocouple.

Each of the conformal electronic devices 524a/524b includes conformal lead wires 534 that have been deposited onto the compliant layer 526, for example using one of the deposition techniques described above. The conformal lead wires 534 serve as the functional conductive elements of the respective conformal electronic devices 524a/524b. The conformal lead wires 534 can be formed of at least one transition metal or other material with sufficient electrical conductivity, such as but not limited to, a ceramic or intermetallic. In one example, the transition metal is selected from platinum, palladium, rhodium, and combination thereof. In further examples, each of the conformal lead wires 534 are formed of only one transition metal that is pure or substantially pure.

In this example, the article 520 is an arc segment that, once assembled with other like arc segments, will form an annular ring around the outside of a rotor. A surface 522a faces toward a hot core gas path in the engine and is thus exposed to relatively high operating temperatures. The opposed surface 522b faces away from the core gas path and is thus at a lower operating temperature. In this regard, the surface 522a provides a hot surface zone on which the conformal electronic devices 524a/524b are disposed. In each case, the conformal lead wires 534 extend from the respective conformal electronic devices 524a/524b around the edges of the ceramic-based substrate 522 and onto the opposed side 522b. The opposed side 522b provides a cold surface zone where the conformal lead wires 534 terminate. The conformal lead wires 534 can be joined to external jumper connections 536 in the cold surface zone, for collecting data signals obtained from the conformal electronic devices 524a/524b. Such external jumper connections 536 would likely prematurely detach if attached in the hot surface zone. By routing the conformal lead wires 534 to the cold surface zone on the opposed side 522b, the lower thermo-mechanical forces permit more reliable connections with the jumpers 536. As can be appreciated, in further examples, one or more conformal electronic device or devices can additionally or alternatively be on cold surface zones.

Although a combination of features is shown in the illustrated examples, not all of them need to be combined to realize the benefits of various embodiments of this disclosure. In other words, a system designed according to an embodiment of this disclosure will not necessarily include all of the features shown in any one of the Figures or all of the portions schematically shown in the Figures. Moreover, selected features of one example embodiment may be combined with selected features of other example embodiments.

The preceding description is exemplary rather than limiting in nature. Variations and modifications to the disclosed examples may become apparent to those skilled in the art that do not necessarily depart from the essence of this disclosure. The scope of legal protection given to this disclosure can only be determined by studying the following claims.

## Claims

1. An instrumented article (20; 120; 220; 320; 420; 520) for a gas turbine engine comprising:
a ceramic-based substrate (22);
at least one conformal electronic device (24; 524a, 524b); and
a layer (26) located between the ceramic-based substrate (22) and the at least one conformal electronic device (24), the at least one conformal electronic device (20; 524a; 524b) being deposited on a surface of the layer (26);
**characterised in that**:
the layer (26) is a compliant layer (26) which has a thermal expansion that is intermediate of the thermal expansions of, respectively, the ceramic-based substrate (22) and the at least one conformal electronic device (24).

2. The instrumented article (20; 120; 220; 320; 420; 520) as recited in claim 1, wherein the ceramic-based substrate (22) includes a silicon-based ceramic material.

3. The instrumented article (20; 120; 220; 320; 420; 520) as recited in claim 1 or 2, wherein the ceramic-based substrate (22) is a monolithic ceramic material.

4. The instrumented article (20; 120; 220; 320; 420; 520) as recited in any of claims 1 to 3, wherein the conformal electronic device (24; 524a, 524b) includes conformal conductive lead wires.

5. The instrumented article (20; 120; 220; 320; 420; 520) as recited in any preceding claim, wherein the compliant layer (26) is a silicate.

6. The instrumented article (20; 120; 220; 320; 420; 520) as recited in claim 5, wherein the compliant layer (26) is a rare-earth silicate.

7. The instrumented article (20; 120; 220; 320; 420; 520) as recited in claim 5, wherein the compliant layer (26) is yttrium silicate.

8. The instrumented article (20; 120; 220; 320; 420; 520) as recited in any of claims 1 to 4, wherein the compliant layer (26) is compositionally graded.

9. The instrumented article (20; 120; 220; 320; 420; 520) as recited in claim 8, wherein the compliant layer (26) is compositionally graded with respect to concentration of yttrium disilicate, yttrium monosilicate, and silica.

10. The instrumented article (420; 520) as recited in any preceding claim, wherein the at least one conformal electronic device includes a plurality of different kinds of conformal electronic devices (24; 524a, 524b).

11. The instrumented article (420; 520) as recited in any of claims 1 to 9, wherein the at least one conformal electronic device includes a plurality of conformal electronic devices (24; 524a, 524b), and the conformal electronic devices (24; 524a, 524b) are stacked at different vertical distances from the surface of the ceramic-based substrate (22).

12. The instrumented article (420) as recited in claim 11, further including respective interleave layers (430) between, and separating, the conformal electronic devices (24).

13. The instrumented article (220; 320) as recited in any preceding claim, further including a protective layer (230) over the at least one conformal electronic device (24).

14. The instrumented article (320) as recited in claim 13, further including a bond layer (332) located between the protective layer (230) and the at least one conformal electronic device (24).

15. The instrumented article (520) as recited in any preceding claim, wherein the ceramic-based substrate (522) is a gas turbine engine article defining, relative to one another, a hot surface zone (522a) and a cold surface zone (522b), and the at least one conformal electronic device (524b) is located in the hot surface zone (522a), with conformal lead wires (536) that are connected to the at least one conformal electronic device (524b), and the conformal lead wires (536) extend from the at least one conformal electronic device (524b) and terminate in the cold surface zone (522b).

## Patentansprüche

1. Instrumentierter Artikel (20; 120; 220; 320; 420; 520) für ein Gasturbinentriebwerk, der Folgendes umfasst:
ein Substrat (22) auf Keramikbasis;
mindestens eine konforme elektronische Vorrichtung (24; 524a, 524b); und
eine Schicht (26), die zwischen dem Substrat (22) auf Keramikbasis und der mindestens einen konformen elektronischen Vorrichtung (24) positioniert ist, wobei die mindestens eine konforme elektronische Vorrichtung (20; 524a; 524b) auf einer Oberfläche der Schicht (26) angeordnet ist;
**dadurch gekennzeichnet, dass**:
die Schicht (26) eine nachgiebige Schicht (26) ist, die eine Wärmeausdehnung aufweist, die zwischen den Wärmeausdehnungen von jeweils dem Substrat (22) auf Keramikbasis und der mindestens einen konformen elektronischen Vorrichtung (24) liegt.

2. Instrumentierter Artikel (20; 120; 220; 320; 420; 520) nach Anspruch 1, wobei das Substrat (22) auf Keramikbasis ein Keramikmaterial auf Siliziumbasis einschließt.

3. Instrumentierter Artikel (20; 120; 220; 320; 420; 520) nach Anspruch 1 oder 2, wobei das Substrat (22) auf Keramikbasis ein monolithisches Keramikmaterial ist.

4. Instrumentierter Artikel (20; 120; 220; 320; 420; 520) nach einem der Ansprüche 1 bis 3, wobei die konforme elektronische Vorrichtung (24; 524a, 524b) konforme leitfähige Leitungsdrähte einschließt.

5. Instrumentierter Artikel (20; 120; 220; 320; 420; 520) nach einem der vorhergehenden Ansprüche, wobei die nachgiebige Schicht (26) ein Silikat ist.

6. Instrumentierter Artikel (20; 120; 220; 320; 420; 520) nach Anspruch 5, wobei die nachgiebige Schicht (26) ein Seltenerdsilikat ist.

7. Instrumentierter Artikel (20; 120; 220; 320; 420; 520) nach Anspruch 5, wobei die nachgiebige Schicht (26) ein Yttriumsilikat ist.

8. Instrumentierter Artikel (20; 120; 220; 320; 420; 520) nach einem der Ansprüche 1 bis 4, wobei die nachgiebige Schicht (26) in der Zusammensetzung abgestuft ist.

9. Instrumentierter Artikel (20; 120; 220; 320; 420; 520) nach Anspruch 8, wobei die nachgiebige Schicht (26) in der Zusammensetzung in Bezug auf die Konzentration von Yttriumdisilikat, Yttriummonosilikat und Siliziumoxid abgestuft ist.

10. Instrumentierter Artikel (420; 520) nach einem der vorhergehenden Ansprüche, wobei die mindestens eine konforme elektronische Vorrichtung eine Vielzahl von verschiedenen Arten von konformen elektronischen Vorrichtungen (24; 524a, 524b) einschließt.

11. Instrumentierter Artikel (420; 520) nach einem der Ansprüche 1 bis 9, wobei die mindestens eine konforme elektronische Vorrichtung eine Vielzahl von konformen elektronischen Vorrichtungen (24; 524a, 524b) einschließt, und wobei die konformen elektronischen Vorrichtungen (24; 524a, 524b) bei verschiedenen vertikalen Distanzen von der Oberfläche des Substrats (22) auf Keramikbasis gestapelt sind.

12. Instrumentierter Artikel (420) nach Anspruch 11, ferner einschließend jeweilige Zwischenblattschichten (430) zwischen den konformen elektronischen Vorrichtungen (24) und diese trennend.

13. Instrumentierter Artikel (220; 320) nach einem der vorhergehenden Ansprüche, ferner einschließend eine Schutzschicht (230) über der mindestens einen konformen elektronischen Vorrichtung (24).

14. Instrumentierter Artikel (320) nach Anspruch 13, ferner einschließend eine Bindungsschicht (332), die zwischen der Schutzschicht (230) und der mindestens einen konformen elektronischen Vorrichtung (24) positioniert ist.

15. Instrumentierter Artikel (520) nach einem der vorhergehenden Ansprüche, wobei das Substrat (522) auf Keramikbasis ein Gasturbinentriebwerkartikel ist, der relativ zueinander einen Bereich (522a) mit einer heißen Oberfläche und einen Bereich (522b) mit einer kalten Oberfläche definiert, wobei die mindestens eine konforme elektronische Vorrichtung (524b) in dem Bereich (522a) mit der heißen Oberfläche mit konformen Leitungsdrähten (536), die mit der mindestens einen konformen elektronischen Vorrichtung (524b) verbunden sind, positioniert ist, und wobei die konformen Leitungsdrähte (536) sich von der mindestens einen konformen elektronischen Vorrichtung (524b) erstrecken und in dem Bereich (522b) mit der kalten Oberfläche enden.

## Revendications

1. Article instrumenté (20 ; 120 ; 220 ; 320 ; 420 ; 520) pour un moteur à turbine à gaz comprenant :
un substrat à base de céramique (22) ;
au moins un dispositif électronique conforme (24 ; 524a, 524b) ; et
une couche (26) située entre le substrat à base de céramique (22) et l'au moins un dispositif électronique conforme (24), l'au moins un dispositif électronique conforme (20 ; 524a ; 524b) étant déposé sur une surface de la couche (26) ;
**caractérisé en ce que** :
la couche (26) est une couche souple (26) qui a une expansion thermique qui est intermédiaire des expansions thermiques, respectivement, du substrat à base de céramique (22) et de l'au moins un dispositif électronique conforme (24).

2. Article instrumenté (20 ; 120 ; 220 ; 320 ; 420 ; 520) selon la revendication 1, dans lequel le substrat à base de céramique (22) inclut un matériau céramique à base de silicium.

3. Article instrumenté (20 ; 120 ; 220 ; 320 ; 420 ; 520) selon la revendication 1 ou 2, dans lequel le substrat à base de céramique (22) est un matériau céramique monolithique.

4. Article instrumenté (20 ; 120 ; 220 ; 320 ; 420 ; 520) selon l'une quelconque des revendications 1 à 3, dans lequel le dispositif électronique conforme (24 ; 524a, 524b) inclut des fils de sortie conducteurs conformes.

5. Article instrumenté (20 ; 120 ; 220 ; 320 ; 420 ; 520) selon une quelconque revendication précédente, dans lequel la couche souple (26) est un silicate.

6. Article instrumenté (20 ; 120 ; 220 ; 320 ; 420 ; 520) selon la revendication 5, dans lequel la couche souple (26) est un silicate de terre rare.

7. Article instrumenté (20 ; 120 ; 220 ; 320 ; 420 ; 520) selon la revendication 5, dans lequel la couche souple (26) est du silicate d'yttrium.

8. Article instrumenté (20 ; 120 ; 220 ; 320 ; 420 ; 520) selon l'une quelconque des revendications 1 à 4, dans lequel la couche souple (26) présente un gradient de composition.

9. Article instrumenté (20 ; 120 ; 220 ; 320 ; 420 ; 520) selon la revendication 8, dans lequel la couche souple (26) présente un gradient de composition par rapport à la concentration de disilicate d'yttrium, de monosilicate d'yttrium, et de silice.

10. Article instrumenté (420 ; 520) selon une quelconque revendication précédente, dans lequel l'au moins un dispositif électronique conforme inclut une pluralité de différents types de dispositifs électroniques conformes (24 ; 524a, 524b).

11. Article instrumenté (420 ; 520) selon l'une quelconque des revendications 1 à 9, dans lequel l'au moins un dispositif électronique conforme inclut une pluralité de dispositifs électroniques conformes (24 ; 524a, 524b), et les dispositifs électroniques conformes (24 ; 524a, 524b) sont empilés à différentes distances verticales de la surface du substrat à base de céramique (22).

12. Article instrumenté (420) selon la revendication 11, incluant en outre des couches intercalées respectives (430) entre, et séparant, les dispositifs électroniques conformes (24) .

13. Article instrumenté (220 ; 320) selon une quelconque revendication précédente, incluant en outre une couche de protection (230) sur l'au moins un dispositif électronique conforme (24).

14. Article instrumenté (320) selon la revendication 13, incluant en outre une couche de liaison (332) située entre la couche de protection (230) et l'au moins un dispositif électronique conforme (24).

15. Article instrumenté (520) selon une quelconque revendication précédente, dans lequel le substrat à base de céramique (522) est un article de moteur à turbine à gaz définissant, l'une par rapport à l'autre, une zone de surface chaude (522a) et une zone de surface froide (522b), et l'au moins un dispositif électronique conforme (524b) est situé dans la zone de surface chaude (522a), avec des fils de sortie conformes (536) qui sont reliés à l'au moins un dispositif électronique conforme (524b), et les fils de sortie conformes (536) s'étendent à partir de l'au moins un dispositif électronique conforme (524b) et se terminent dans la zone de surface froide (522b).
